# EUROPEAN PATENT SPECIFICATION

(11) **EP 2 785 157 B1**
(45) Date of publication and mention of the grant of the patent: **16.11.2016**
(21) Application number: 12851074.0
(22) Date of filing: 26.11.2012
(51) Int. Cl.: H05K 1/09, H05K 3/12, C09D 5/24, C09D 7/12, C09D 171/02, C09D 201/00, H01B 1/00, H01B 1/22, H01B 13/00, C08K 3/08

(54) **CONDUCTIVE PATTERN FORMATION METHOD AND COMPOSITION FOR FORMING CONDUCTIVE PATTERN VIA PHOTO IRRADIATION**
VERFAHREN ZUR BILDUNG EINER LEITFÄHIGEN STRUKTUR UND ZUSAMMENSETZUNG ZUR BILDUNG EINER LEITFÄHIGEN STRUKTUR DURCH LICHTBESTRAHLUNG
PROCÉDÉ DE FORMATION DE MOTIFS CONDUCTEURS ET COMPOSITION POUR FORMER UN MOTIF CONDUCTEUR PAR IRRADIATION DE LUMIÈRE

(30) Priority: 24.11.2011 JP 2011256509
(43) Date of publication of application: 01.10.2014
(73) Proprietor: Showa Denko K.K., Tokyo 105-8518 (JP)
(72) Inventor: UCHIDA, Hiroshi, Tokyo 105-8518 (JP)
(74) Representative: Strehl Schübel-Hopf & Partner
(86) International application number: PCT/JP2012/080464
(87) International publication number: WO 2013/077447

(56) References cited:
- WO-A1-2007/026812
- WO-A1-2010/045639
- WO-A2-2010/067965
- WO-A2-2010/101418
- JP-A- H08 148 032
- JP-A- 2004 221 146
- JP-A- 2004 319 781
- JP-A- 2004 362 950
- JP-A- 2006 173 408
- JP-A- 2007 207 567
- JP-A- 2008 293 821
- JP-A- 2009 033 034
- JP-A- 2009 070 677
- JP-A- 2009 283 547
- JP-A- 2009 533 552
- JP-A- 2010 109 334
- US-A1- 2004 106 718

## Description

### TECHNICAL FIELD

The present disclosure relates to the improvement of a conductive pattern formation method and a composition for forming a conductive pattern by means of photo irradiation.

### BACKGROUND ART

As a technique for forming a fine wiring pattern, conventionally, a method for forming a wiring pattern to form a wiring pattern by a lithographic method using a combination of a copper foil and a photoresist has been generally employed. This method, however, includes many steps, and imposes a large burden on treating drain and waste fluid, and therefore is desired to be improved from an environmental point of view. Further, a method for patterning a metal thin film according to a photolithographic method, the metal thin film being formed according to a heat deposition method or a sputtering method, has also been known. However, a heat deposition method and a sputtering method require vacuum environment, and are very costly. Therefore, it is difficult to reduce manufacturing costs when these methods are applied to a wiring pattern.

In view of the above, a technique for forming a wiring pattern by means of printing using an ink containing metal or metal oxide has been proposed. As a wiring technique by means of printing enables high-speed production of a large amount of products at lower costs, some people have already started examining practicable application of the technique to the formation of an electronic device.

However, a method for sintering a metal- or metal oxide-containing ink in a heating furnace has problems that a long period of time is required at a heating step, and that when a plastic substrate is not resistant to the heating temperature, satisfactory conductivity cannot be attained.

In view of the above, it has been attempted to convert a composition (ink) containing nanoparticles into a metal wiring by means of photo irradiation , as described in Patent Documents 1 to 3.

A method using photo energy or microwaves to heat can heat an ink part only, and thus is a very good method. However, the method has a problem that, when metal particles themselves are used, conductivity of a resultant conductive pattern is not satisfactorily improved, and a problem that, when copper oxide is used, a resultant conductive pattern has a large void ratio or a part of the copper oxide particles remains unreduced.

Further, such sintering requires the use of metal or metal oxide particles each having at least a diameter of 1 µm or less, which rises a problem that preparation of such nanoparticles requires large costs.

### Related Art Document

### Patent Document

Patent Document 1: National Publication JP 2008-522369
Patent Document 2: WO2010/110969
Patent Document 3: National Publication JP 2010-528428

Further relevant background art is disclosed in documents US 2004/106718, WO 2010/101418 and JP 2010 109 334.

### SUMMARY

In general, it is considered that, as to a conductive pattern formed on a substrate, one having higher conductivity (low volume resistivity) is of higher performance. Therefore, it is desirable to improve conductivity of a conductive pattern formed according to the above mentioned conventional technique.

An object of the present disclosure is to provide a conductivity pattern formation method and a composition for forming a conductivity pattern by means of photo irradiation, capable of improving conductivity of a conductive pattern.

In order to achieve the above mentioned object, according to an aspect of the present disclosure, there is provided a composition for forming a conductive pattern by means of photo irradiation as defined in claim 1.

Further, the thickness of the silver particle may be 20 to 70 nm. An aspect ratio of the silver particle may be 5 to 200.

Further, the shape of the copper particle may be spherical, and the number median diameter D50 of the particles may be 100 nm to 10 µm.

Further, the composition forming a conductive pattern may further comprise a reducing agent.

Further, the reducing agent may be a polyhydric alcohol, a carboxylic acid, or a polyalkylene glycol.

Further, according to another aspect of the invention, there is provided a conductive pattern forming method as defined in claim 9, comprising preparing the above mentioned composition for forming a conductive pattern, and applying photo irradiation or microwave heating to the composition for forming a conductive pattern.

Further, light to be irradiated to the composition may be a pulsed light having a wavelength of 200 to 3000 nm.

### Effect of the invention

According to the present disclosure, it is possible to obtain a conductive pattern formation method and a composition for forming a conductive pattern by means of photo irradiation, capable of improving conductivity of a conductive pattern.

### BRIEF DESCRIPTION OF DRAWINGS

FIG. 1 explains a definition of a pulsed light;
FIG. 2 shows a surface SEM picture of an electric conductive film formed in an example;
FIG. 3 explains an outline of a water drop test;
FIG. 4 explains an outline of a pattern and a method for forming a test piece used in a water drop test;
FIG. 5 shows a result of a water drop test using an ink according to Example 8; and
FIG. 6 shows a result of a water drop test using an ink according to Comparative Example 5.

### DETAILED DESCRIPTION

In the following, an exemplary embodiment for rendering the present disclosure into practice (hereinafter referred to as an embodiment) will be described.

A composition for forming a conductive pattern by means of photo irradiation according to the embodiment contains copper particles, plate-like silver particles each having 10 to 200 nm in thickness, and a binder resin. Note that a reducing agent may be included in the above mentioned composition.

A conductive pattern formation method according to the embodiment, comprises: preparing the above mentioned composition for forming a conductive pattern; applying photo irradiation or microwave heating to the composition for forming a conductive pattern to produce a sintered body of copper and silver; and thereby, obtaining a conductive pattern. Preparation here refers to, for example, formation of a composition layer in an arbitrary shape on an appropriate substrate, using the above mentioned composition for forming a conductive pattern, by means of screen printing, gravure printing, or the like, or using a print device, such as an ink jet printer, or the like. More specifically, preparation refers to formation of a printed pattern, using the above mentioned composition for forming a conductive pattern, or formation of the above mentioned composition layer over the entire surface of a substrate (hereinafter referred to as an entire surface covering pattern). Note that in this specification, a conductive pattern refers to a conductive film that is a conductive metal thin film that is made of metal formed in a pattern (including the entire surface covering pattern) as a result of sintering copper particles and silver particles by forming a composition containing copper particles and silver particles dispersed in a binder resin into a printed pattern, and then applying photo irradiation thereto.

Preferably, a particle diameter of the above described copper particle is 100 nm to 10 µm, and more preferably, within the range between 200 nm and 5 µm. Absence of copper oxide on the surface of a copper particle is preferable. However, even when copper oxide is present on the entire or a part of the surface, conversion into a conductive pattern by means of photo irradiation or microwave heating is possible, if a reducing agent is present. Further, a copper oxide film present on a part of the surface may be a film of either cuprous oxide or cupric oxide. As a proportion of copper oxide, the ratio of copper oxide analyzed in XRD is 10 mass% or less, preferably, 5 mass% or less, more preferably, 3 mass% or less. If the copper oxide ratio exceeds 10 mass%, the reduction rate of the volume resistivity of a formed conductive pattern is decreased. Further, even though the amount of copper oxide initially present on the surface is as small as being almost not detectable in XRD, copper oxide may be generated by surface oxidization which occurs during the preparation of an ink (a composition for forming a conductive pattern) in air and during the printing step. Therefore, preferably, a reducing agent may be used in preparation of an ink.

A copper particle having a particle diameter smaller than 100 nm has a larger specific surface area, and thus, can be oxidized very easily. Therefore, it is difficult to use such copper particles as metal copper particles. When the particle diameter is in excess of 10 µm, there is a problem that fine pattern printing is not possible.

Note that a particle diameter of the above mentioned copper particle and copper oxide particle means a particle diameter D50 (a median diameter) based on the number of particles that is obtained in measurement using a laser diffraction and scattering method in a case of a particle diameter equal to 500 nm or larger, or a dynamic light scattering method in a case of a particle diameter smaller than 500 nm.

Further, the above mentioned silver particle is a plate-like (flat) particle. The shape of the plate-like silver particle is obtained by measuring thickness and width of each silver particle using SEM observation at x30000 magnification at ten different observation points. As to the thickness, the number average thickness is obtained. The thickness is 10 to 200 nm, as described above, and preferably, in the range between 20 nm and 70 nm.

As to an aspect ratio (width/thickness of a silver particle), no effect of connecting copper particles can be obtained unless the aspect ratio is large to some extent. However, if the aspect ratio is too large, there are drawbacks that the print accuracy may be decreased, and dispersion with copper particles may not be performed well. In view of the above, preferably, an aspect ratio is in the range between 5 and 200 and, more preferably, between 5 and 100. With an aspect ratio smaller than 5, conductivity can be hardly expressed, while with an aspect ratio larger than 200, it is difficult to achieve fine pattern printing.

If the thickness of a silver particle exceeds 200 nm, the silver particle is hard to be deformed, and thus copper particles cannot be adhered to the silver particle. Meanwhile, if the thickness of a silver particle is smaller than 10 nm, the strength of a silver particle itself is lowered, and copper particles cannot be adhered to the silver particle. That is, in either case, adhesiveness with copper particles at a sintering step is lowered, so that sufficient improvement in conductivity of a formed conductive layer cannot be achieved.

Further, as to a mixing ratio (a mass ratio) of the copper particles and silver particles in the above mentioned mixture, an excessively small ratio of silver particles cannot attain sufficient improvement in conductivity, while an excessively large ratio of silver particles readily causes a defect, such as ion migration or the like, of silver particles. In view of the above, the ratio of copper particles and silver particles is in the range between 99:1 and 50:50, and preferably, between 99:1 and 70:30, and yet preferably, between 98:2 and 80:20.

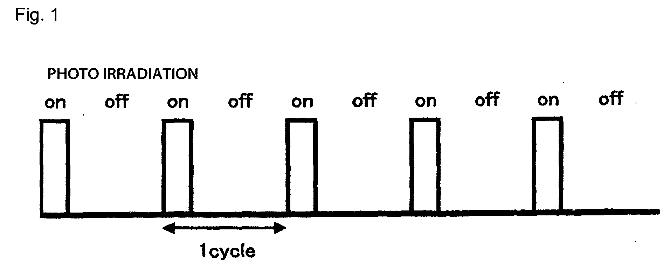

As light to be irradiated to a composition, a pulsed light having a wavelength of 200 nm to 3000 nm is preferable. Note that a "pulsed light" in this specification refers to light having a short photo irradiation period (irradiation time) being a few microseconds to several tens of milliseconds. Repetitive photo irradiation refers to photo irradiation including a period of time with no light irradiated (an irradiation interval (off)) intervening between a first photo irradiation period (on) and a second photo irradiation period (on), as shown in FIG. 1. Although light intensity of the pulse light is shown constant in FIG. 1, light intensity may vary during a single photo irradiation period (on). The above mentioned pulsed light is irradiated from a light source provided with a flash lamp, such as a xenon flash lamp. Using such a light source, a pulsed light is irradiated to a layer of the above mentioned composition. For repetitive irradiation for n number of times, a single cycle (on+off) shown in FIG. 1 is repeated for n times. Note that in repetitive irradiation, it is preferable to cool from the substrate side before the next pulsed light irradiation so that the substrate can be cooled down to near room temperature.

As a single pulsed light irradiation period (on), a range between about 20 microseconds and about 10 milliseconds is preferable. An irradiation period shorter than 20 microseconds does not promote sintering, which results in lower effect of improvement in performance of an electrical conductive film. Meanwhile, an irradiation period longer than 10 milliseconds results in larger adverse effect due to photo deterioration or heat deterioration of the substrate. Although single irradiation of a pulsed light is effective, repetitive irradiation as described above is possible. For repetitive irradiation, an interval (off) is preferably from 20 microseconds to 30 seconds, and, more preferably, from 2000 microseconds to 5 seconds. With an interval shorter than 20 microseconds, the pulsed light becomes similar to continuous light. That is, as irradiations succeed without having a sufficient cooling period after each irradiation, there is a possibility that the substrate is heated and the temperature increases until the substrate is deteriorated. Meanwhile, with an interval longer than 30 seconds, cooling further proceeds, and thus, effect of repetitive irradiation lessens though some effect can be obtained.

Further, a composition can be heated by microwave. Microwave used to heat a composition is an electromagnetic wave having a wavelength ranging between 1 m and 1 mm (frequency is 300 MHz to 300 GHz).

Note that the above mentioned substrate is not limited to any particular one, and for example, a plastic substrate, a glass substrate, a ceramic substrate, and the like can be used.

As a reducing agent, a monohydric alcohol compound, such as methanol, ethanol, isopropyl alcohol, butanol, cyclohexanol, and terpineol; polyhydric alcohol, such as ethylene glycol, propylene glycol, and glycerin; a carboxylic acid, such as formic acid, acetic acid, oxalic acid, and succinic acid; a carbonyl compound, such as acetone, methyl ethyl ketone, benzaldehyde, and octyl aldehyde; an ester compound, such as ethyl acetate , butyl acetate, and phenyl acetate; a lactone compound, such as γ-butyrolactone; and a hydrocarbon compound, such as hexane, octane, toluene, naphthalene, decalin, and cyclohexane can be used. Among those mentioned above, polyhydric alcohol, such as ethyleneglycol, propyleneglycol, glycerin and the like, and carboxylic acid, such as formic acid, acetic acid, and oxalic acid are preferable in view of the efficiency of a reducing agent. However, when the percentage of copper oxide is small, organic solvent other than those mentioned above can be used as a reducing agent.

In order to print a composition for forming a conductive pattern containing metal copper and silver particles, a binder resin is necessary. It is possible to use a binder resin that functions also as a reducing agent. A polymer compound capable of functioning also as a reducing agent may be a thermoplastic resin or a thermoset resin which is, for example, a poly-N-vinyl compound such as polyvinylpyrrolidone or polyvinyl caprolactone, a polyalkylene glycol compound such as polyethylene glycol, polypropylene glycol, or poly THF, polyurethane, a cellulose compound and a derivative thereof, an epoxy compound, a polyester compound, chlorinated polyolef in, a polyacrylic compound, and the like. Among those mentioned above, polyvinylpyrrolidone, phenoxy type epoxy resin that remains solid at normal temperature, and cellulose compound are preferable in view of efficiency of binder effect, while polyethylene glycol, polypropylene glycol, and a polyurethane compound are preferable in view of efficiency of reduction effect. Note that polyethylene glycol and polypropylene glycol are classified as polyhydric alcohol, and has particularly preferable property as a reducing agent.

Presence of a binder resin is essential. However, use of an excessively large amount of binder resin causes a problem that conductivity is unlikely to be expressed, while use of an excessively small amount of binder resin lowers the ability of connecting particles. In view of the above, the amount of binder resin to be used is, preferably, 1 to 50 parts by mass, more preferably, 3 to 20 parts by mass, relative to the total amount of metal copper and silver particles, 100 parts by mass.

Although different solvent may be used depending on a desired printing method, a publicly known organic solvent, a water solvent, or the like can be used.

Note that a composition for forming a conductive pattern according to the embodiment may contain a publicly known ink additive (antifoaming agent, surface modifier, thixotropic agent, and the like).

This embodiment is characterized in that photo irradiation is applied to a composition for forming a conductive pattern containing copper particles, silver particles mainly comprised of plate-like particles, and a reducing agent, to thereby produce a copper/silver sintered body to form a conductive pattern. In this case, when photo irradiation is applied in the presence of a reducing agent, copper oxide on the surface of a copper particle is reduced into metal copper, and sintered with a plate-like silver particle.

The silver particles should be mainly comprised of plate-like particles. The use of a spherical silver particle cannot increase the surface area to be in contact with the copper particle so that volume resistivity of a resultant electrical conductive film cannot be sufficiently reduced. Therefore, preferably, a silver particle has a plate-like shape having the above mentioned aspect ratio. Note that a silver particle having a shape other than a plate-like shape, such as, for example, a spherical shape, a needle shape, and so forth, may be included at a ratio of 20 mass% or lower relative to the entire silver particles.

### [Examples]

In the following, examples of the present disclosure will be specifically described. Note that the examples described below are only to help readily understanding of the present disclosure, and the present disclosure is not limited to these examples.

Further, in the examples and comparative examples described below, volume resistivity was measured using Loresta GP manufactured by Mitsubishi Chemical Analytech Co., Ltd. Sizes of respective particles were measured using Microtrac Particle Size Distribution Measurement Device MT3000II Series USVR (a laser diffraction and scattering method) or Nanotrac UPA-EX150 (a dynamic light scattering method) manufactured by Nikkiso Co., Ltd., and particle diameters were obtained by spherical approximation, and the median diameter is determined as D50. The shape of a plate-like (flat) silver particle is obtained by means of ten-point image capturing using FE-SEM S-5200 manufactured by Hitachi High-Technologies Corporation, and a number average of the actually measured values is obtained for the thickness.

### Example 1

Polyvinylpyrrolidone (made by Nippon Shokubai Co., Ltd.) as a binder was dissolved into a mixed aqueous solution of ethyleneglycol and glycerin (a reagent made by Kanto Chemical Co., Inc.) as a reducing agent to prepare a binder solution of 40 mass%. A mass ratio of ethyleneglycol and glycerin and water in the mixed aqueous solution is 70:15:15. Then, 1.5 g of this solution was mixed with 0.5 g of the above mentioned mixed aqueous solution, into which 5.4 g of copper powder 1050Y (spherical, D50=716 nm) made by Mitsui Mining and Smelting Co., Ltd. and 0.6 g of N300 as silver particles (flat (thickness: 30 nm), D50=470 nm) made by Tokusen Co., Ltd. were mixed (copper particles: silver particles = 90:10), and well mixed using Planetary Centrifugal Vacuum Mixer "Thinky Mixer" (AWATORI RENTAROU) ARV-310 (manufactured by Thinky Corporation) to prepare a paste for printing (composition for forming a conductive pattern).

The obtained paste was printed on a polyimide film (Kapton 100V, made by Du Pont-Toray Co., Ltd., 25 µm thickness) in a 2 cm x 2 cm square pattern by means of screen printing. Then, a pulsed light was irradiated to the sample obtained as described above, using Sinteron 2000 manufactured by Xenone, to thereby convert the printed pattern into a conducive pattern. Irradiation conditions included a pulsed width of 2000 microseconds, a voltage of 3000 V, and single-shot irradiation with an irradiation distance 20 cm. The pulse energy at that time was 2070J. The thickness of a conductive pattern formed as described above was 22 µm. The above described series of processing was performed in air.

### Example 2

5.4 g of copper powder 1100Y made by Mitsui Mining & Smelting Co., Ltd. (spherical, D50=1110 nm) and 0.6 g of N300 as silver particles (flat (thickness: 30 nm), D50=470 nm) made by Tokusen Co., Ltd. were used to prepare a paste for printing in the same manner as that in Example 1. The obtained paste was printed in a pattern in the same manner as that in Example 1, and subjected to photo irradiation. The thickness of the conductive pattern formed was 23 µm.

### Example 3

5.4 g of copper powder 1400Y made by Mitsui Mining & Smelting Co., Ltd. (spherical, D50=5700 nm) and 0.6 g of N300 as silver particles (flat (thickness: 30 nm), D50=470 nm) made by Tokusen Co., Ltd. were used to prepare a paste for printing in the same manner as that in Example 1. The obtained paste was printed in a pattern in the same manner as that in Example 1, and subjected to photo irradiation. The thickness of the conductive pattern formed was 26 µm.

### Example 4

5.4 g of copper powder MA-C04J (atomized powder, D50=4640 nm) made by Mitsui Mining & Smelting Co., Ltd. and 0.6 g of N300 as silver particles (flat (thickness: 30 nm), D50=470 nm) made by Tokusen Co., Ltd. were used to prepare a paste for printing in the same manner as that in Example 1. The obtained paste was printed in a pattern in the same manner as that in Example 1, and subjected to photo irradiation. The thickness of the conductive pattern formed was 27 µm.

### Example 5

5.7 g of copper powder 1020Y (spherical, D50=380 nm) made by Mitsui Mining & Smelting Co., Ltd. and 0.3 g of N300 as silver particles (flat (thickness: 30 nm), D50=470 nm) made by Tokusen Co., Ltd. were used (copper particles: silver particles =95:5) to prepare a paste for printing in the same manner as that in Example 1. The obtained paste was printed in a pattern in the same manner as that in Example 1, and subjected to photo irradiation. The thickness of the conductive pattern formed was 24 µm.

### Example 6

5.4 g of copper powder 1020Y (spherical, D50=380 nm) made by Mitsui Mining & Smelting Co., Ltd. and 0.6 g of N300 as silver particles (flat (thickness: 30 nm), D50=470 nm) made by Tokusen Co., Ltd. were used (copper particles:silver particles =90:10) to prepare a paste for printing in the same manner as that in Example 1. The obtained paste was printed in a pattern in the same manner as that in Example 1, and subjected to photo irradiation. The thickness of the conductive pattern formed was 23 µm.

### Example 7

4.8 g of copper powder 1020Y (spherical, D50=380 nm) made by Mitsui Mining & Smelting Co., Ltd. and 1.2g of N300 as silver particles (flat (thickness: 30 nm) D50=470 nm) made by Tokusen Co., Ltd. were used (copper particles; silver particles =80:20) to prepare a paste for printing in the same manner as that in Example 1. The obtained paste was printed in a pattern in the same manner as that in Example 1, and subjected to photo irradiation. The thickness of the conductive pattern formed was 22 µm.

### Example 8

5.4 g of copper powder 1020Y (spherical, D50=380 nm) made by Mitsui Mining & Smelting Co., Ltd. and 0.6 g of M13 as silver particles (flat (thickness: 40 nm), D50=2270 nm) made by Tokusen Co., Ltd. were used (copper particles: silver particles = 90:10) to prepare a paste for printing in the same manner as that in Example 1. The obtained paste was printed in a pattern in the same manner as that in Example 1, and subjected to photo irradiation. The thickness of the conductive pattern formed was 23 µm.

### Example 9

A phenoxy type epoxy resin jER1256 (made by Mitsubishi Chemical Corporation) is dissolved as a binder in γ-butyrolactone to prepare a binder solution of 35 mass%. 1.429 g of this solution is mixed with 0. 47 g of γ-butyrolactone, into which 8.0 g of copper powder 1100Y made by Mitsui Mining & Smelting Co. , Ltd. (spherical, D50=1110 nm) and 2.04 g of N300 as silver particles (flat (thickness: 30 nm), D50=470 nm) made by Tokusen Co., Ltd. were mixed (copper particles: silver particles =80:20), and mixed well using Planetary Centrifugal Vacuum Mixer "Thinky Mixer" (AWATORI RENTAROU) ARV-310 (manufactured by Thinky Corporation) to prepare a paste for printing (a composition for forming a conductive pattern).

The obtained paste was printed on a polyimide film (Kapton 100V, made by Du Pont-Toray Co., Ltd., thickness of 25 µm) in a 2 cm x 2 cm square pattern by means of screen printing. Then, a pulsed light was irradiated to the sample obtained as described above, using Pulse Forge 3300 manufactured by Novacentrix, to thereby convert the printed pattern into a conducive pattern. Under irradiation conditions including a pulse width of 900 microseconds and a voltage of 350 V, a single-shot irradiation was applied to the sample while the sample was carried on a conveyer of the device. The pulse energy at that time was 5630 J/m². The thickness of the conductive pattern formed as described above was 18 µm. The above described series of processing was performed in air.

### Example 10

5.0 g of copper powder 1100Y (spherical, D50=1110 nm) made by Mitsui Mining & Smelting Co., Ltd. and 5.0 g of N300 as silver particles (flat (thickness: 30 nm), D50=470 nm) made by Tokusen Co., Ltd. were used to prepare a paste for printing in the same manner as that in Example 9. The obtained paste was printed in a pattern, and subjected to photo irradiation, whereby the printed pattern is converted into a conductive pattern. The thickness of the formed conductive pattern was 17 µm.

### Comparative Example 1

5.4 g of copper powder 1020Y (spherical, D50=380 nm) made by Mitsui Mining & Smelting Co., Ltd. and 0.6 g of SMI as silver particles (spherical, D50=230 nm) made by Tokusen Co., Ltd. were used to prepare a paste for printing in the same manner as that in Example 1. The obtained paste was printed in a pattern in the same manner as that in Example 1, and then subjected to photo irradiation. The thickness of the formed conductive pattern was 23 µm.

### Comparative Example 2

5.4 g of copper powder 1020Y (spherical, D50=380 nm) made by Mitsui Mining & Smelting Co., Ltd. and 0.6 g of T5A-A10 as silver particles (spherical, D50=30 nm) made by Dowa Electronics Materials Co., Ltd. were used to prepare a paste for printing in the same manner as that in Example 1. The obtained paste was printed in a pattern in the same manner as that in Example 1, and then subjected to photo irradiation. The thickness of the formed conductive pattern was 26 µm.

### Comparative Example 3

5.4 g of copper powder 1020Y (spherical, D50=380 nm) made by Mitsui Mining & Smelting Co., Ltd. and 0.6g of EHD as silver particles (spherical, D50=620 nm) made by Mitsui Mining & Smelting Co., Ltd. were used to prepare a paste for printing in the same manner as that in Example 1. The obtained paste was printed in a pattern in the same manner as that in Example 1, and then subjected to photo irradiation. The thickness of the formed conductive pattern was 18 µm.

### Comparative Example 4

6.0g of copper powder 1020Y (spherical, D50=380 nm) made by Mitsui Mining & Smelting Co., Ltd. (no silver particles were used) to prepare a paste for printing in the same manner as that in Example 1. The obtained paste was printed in a pattern in the same manner as that in Example 1, and then subjected to photo irradiation. The thickness of the formed conductive pattern was 22 µm.

### Comparative Example 5

6.0g of N300 (flat (thickness: 30 nm), D50=470 nm) made by Tokusen Co., Ltd. were used as silver particles (no copper particles were used) to prepare a paste for printing in the same manner as that in Example 1. The obtained paste was printed in a pattern in the same manner as that in Example 1, and then subjected to photo irradiation. The thickness of the formed conductive pattern was 20 µm.

As to each of the conductive patterns made by the above mentioned steps, volume resistivity was measured using Loresta GP volume resistivity (Ω · cm) made by Mitsubishi Chemical Analytech Co., Ltd. The results are shown in Table 1.

**[Table 1]**

| | Cu Particle | Ag Particle | Photoirradiation Conditions | | | | Ratio | | Thickness | Volume Resistivity |
|---|---|---|---|---|---|---|---|---|---|---|
| | | | Device name | Voltage | Time | Irradiation Distance | Cu | Ag | µm | Ω· cm |
| Example 1 | 1050Y | N300 | Sinteron 2000 | 3000 V | 2000 µm | 20 cm | 90 | 10 | 22 | 1.11E-04 |
| Example 2 | 1100Y | N300 | Sinteron 2000 | 3000 V | 2000 µm | 20 cm | 90 | 10 | 23 | 1.56E-04 |
| Example 3 | 1400Y | N300 | Sinteron 2000 | 3000 V | 2000 µm | 20 cm | 90 | 10 | 26 | 8.97E-04 |
| Example 4 | MA-C04J | N300 | Sinteron 2000 | 3000 V | 2000 µm | 20 cm | 90 | 10 | 27 | 6.53E-04 |
| Example 5 | 1020Y | N300 | Sinteron 2000 | 3000 V | 2000 µm | 20 cm | 95 | 5 | 24 | 4.74E-04 |
| Example 6 | 1020Y | N300 | Sinteron 2000 | 3000 V | 2000 µm | 20 cm | 90 | 10 | 23 | 1.68E-04 |
| Example 7 | 1020Y | N300 | Sinteron 2000 | 3000 V | 2000 µm | 20 cm | 80 | 20 | 22 | 1.45E-04 |
| Example 8 | 1020Y | M13 | Sinteron 2000 | 3000 V | 2000 µm | 20 cm | 90 | 10 | 23 | 7.41E-04 |
| Example 9 | 1100Y | N300 | Pulse Forge 3300 | 350V | 900 µm | - | 80 | 20 | 18 | 8.84E-0.5 |
| Example 10 | 1100Y | N300 | Pulse Forge 3300 | 350V | 900 µm | - | 50 | 50 | 17 | 6.16E-06 |
| Comparative Example 1 | 1020Y | SMI | Sinteron 2000 | 3000 V | 2000 µm | 20 cm | 90 | 10 | 23 | 1.90E-01 |
| Comparative Example 2 | 1020Y | T5A-A10 | Sinteron 2000 | 3000 V | 2000 µm | 20 cm | 90 | 10 | 26 | 1.22E-03 |
| Comparative Example 3 | 1020Y | EHD | Sinteron 2000 | 3000 V | 2000 µm | 20 cm | 90 | 10 | 18 | 3.75E-01 |
| Comparative Example 4 | 1020Y | none | Sinteron 2000 | 3000 V | 2000 µm | 20 cm | 100 | 0 | 22 | 3.45E-02 |
| Comparative Example 5 | none | N300 | Sinteron 2000 | 3000 V | 2000 µm | 20 cm | 90 | 10 | 20 | 1.38E-04 |

As shown in Table 1, in any Examples, volume resistivity smaller than those in Comparative Examples 1 to 4 are obtained. This is because, when plate-like (flat) silver particles are adhered to and sintered with copper particles, the adherent area is larger compared to the case that spherical silver particles are adhered to and sintered with copper particles. As a result, although the sizes (D50) of the copper particles are different among Examples, the volume resistivity in any of all Examples is lower than that in Comparative Examples 1 and 2 involving spherical copper particles and spherical silver particles, and in Comparative Example 4 involving copper particles only.

Meanwhile, in Comparative Example 5 involving silver particles only, low volume resistivity, namely, 1.38×10⁻⁴, is resulted. However, as only silver particles are used, higher costs are resulted, and iron migration is likely to be caused.

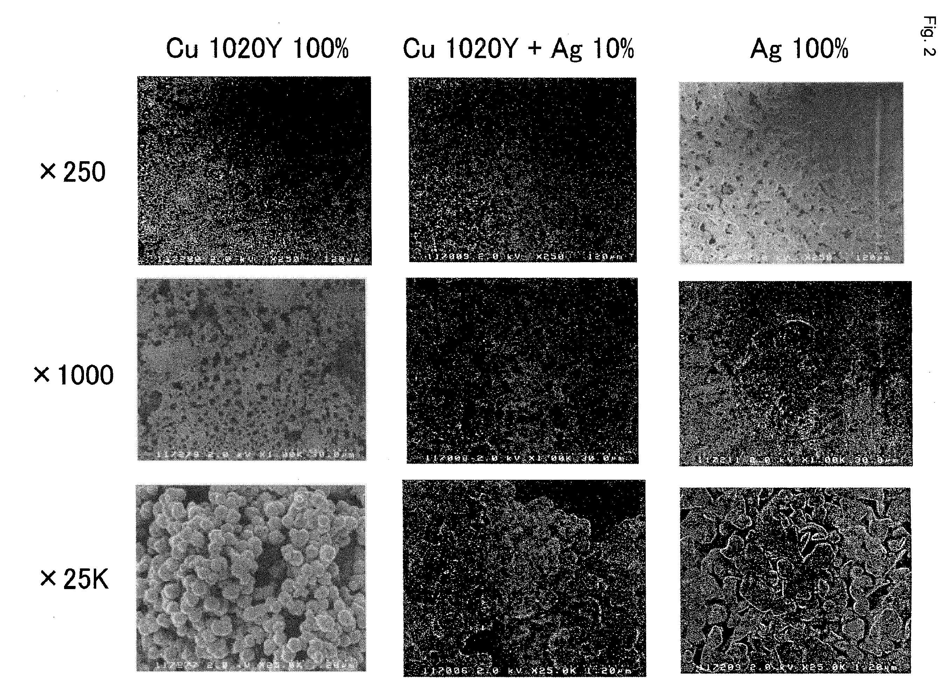

FIG. 2 shows a surface SEM picture of a formed conductive pattern. In FIG. 2, when only silver particles are used (labeled as Ag100%), many holes are caused (a SEM picture at a lower magnification); when only copper particles are used (labeled as Cu1020Y100%), substantially spherical copper particles remain their original shape (a SEM picture at a higher magnification).

Meanwhile, when both of copper particles and plate-like silver particles are used (labeled as Cu1020Y+Ag10%), fewer holes are caused. This is because copper particles are bridged with each other by plate-like silver particles.

### Water Drop Test

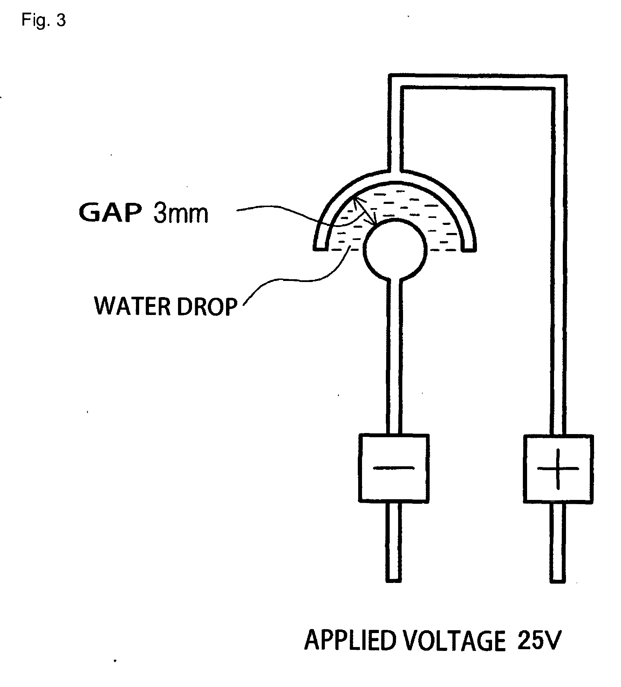

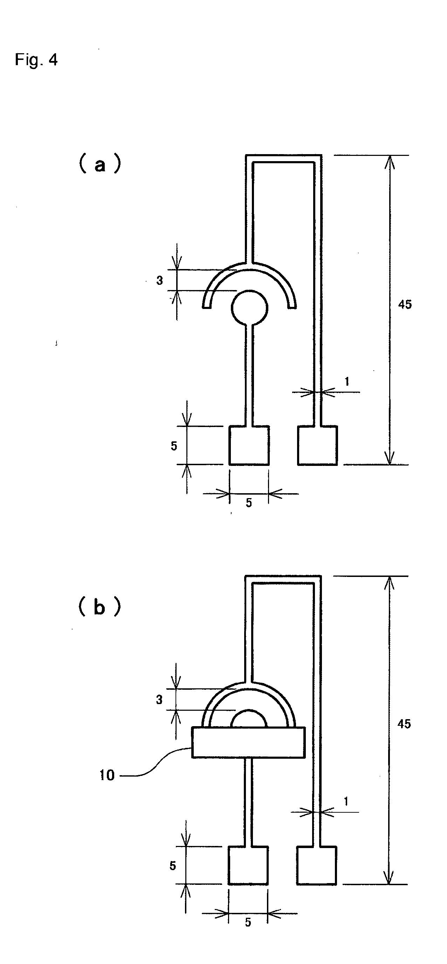

The respective pastes made in Example 9 and Comparative Example 5 were printed in a pattern on a polyimide film (Kapton 100V, made by Du Pont-Toray Co., Ltd., thickness 25µm) using a pattern formation screen panel for a water drop test in the same manner as those Example 9 and Comparative Example 5, respectively, and then subjected to photo irradiation, to thereby convert the printed pattern into a conductive pattern of substantially 20 µm thickness. Then, water was dropped onto these patterns and a voltage 25V was applied to perform a water drop test. FIG. 3 outlines this test. FIG. 4 outlines a pattern (the dimension in mm) and a method for making a test piece used in the test.

In FIG. 3, water was dropped into a gap of 3 mm, and a voltage 25V was applied to see whether or not electromigration was caused. In detail, a conductive pattern for a water drop test, shown in FIG. 4(a), was formed, a Kapton (registered trademark) adhesive tape (tape No.650S□50 made by Teraoka Seisakusho Co., Ltd.) 10 was adhered as shown in FIG. 4(b); a single drop of pure water was dropped onto a semi-concentric recess defined by the surrounding Kapton adhesive tape 10 and the conductive pattern; and a cover glass plate is placed from the above so that the recess was filled with water.

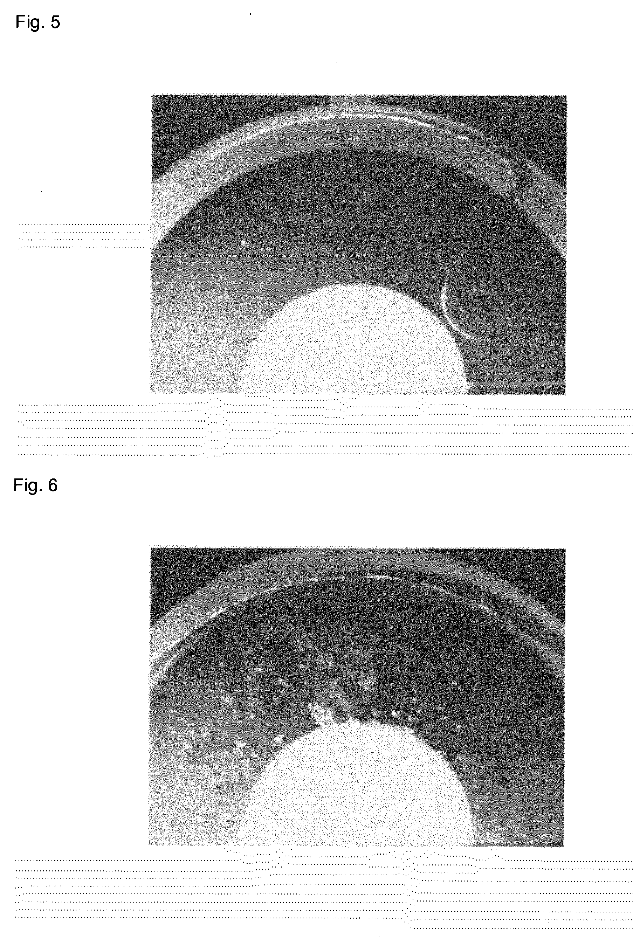

Further, FIGs 5 and 6 respectively show results of water drop tests of conductive patterns using the pastes made in Example 9 and Comparative Example 5, respectively.

As shown in FIG. 6, with a conductive pattern formed using a paste having only silver in Comparative Example 5, electro migration was caused in a rather shorter period of time after the start of the test, as shown in FIG. 6, whereas with a conductive pattern using a copper-silver mixed paste formed in Example 9 of the present disclosure shown in FIG. 5, only few dendrite was seen after 500 seconds. Thus, it was known that tolerance against ion migration was improved, compared to a paste of silver alone.

Note that the shapes of the copper particles and silver particles and the values of D50 used in the above described examples and comparative examples are shown in Table 2.

**[Table 2]**

| **Coexistent Particles** | | **Particle** | | | | |
|---|---|---|---|---|---|---|
| | | **Shape** | **D50** | **Width** | **Thickness** | **Aspect Ratio** |
| | **1020Y** | **Spherical** | **380** | | | |
| | **1050Y** | **Spherical** | **716** | | | |
| **Cu** | **1100Y** | **Spherical** | **1110** | | | |
| | **1400Y** | **Spherical** | **5700** | | | |
| | **MA-C04J** | **Atomized Powder** | **4640** | | | |
| | **SMI** | **Spherical** | **230** | | | |
| | **T5A-A10** | **Spherical** | **30** | | | |
| **Ag** | **N300** | **Flat** | **470** | **350-500** | **30** | **10** |
| | **EHD** | **Spherical** | **620** | | | |
| | **M13** | **Flat** | **2270** | **1000-3000** | **40** | **75** |

As shown in Table 2, the silver particles N 300, M13 used in Examples are flat particles, in which the thickness of N300 is 30 nm and that of M13 is 40 nm. Meanwhile, other silver particles are spherical. Note that D50 was measured also as to the flat silver particles N300 and M13, similar to spherical particles, though the measured values are merely for reference as N300 and M13 are not spherical particles.

### [Description of reference Numeral]

10 Kapton adhesive tape

## Claims

1. A composition for forming a conductive pattern by means of photo irradiation, comprising:
copper particles,
plate-like silver particles each having a thickness of 10 to 200 nm, and
a binder resin,
wherein the mass ratio of the copper particles and the silver particles, represented by copper particles : silver particles, is 99:1 to 50:50.

2. The composition for forming a conductive pattern according to claim 1, wherein the thickness of the silver particle is 20 to 70 nm.

3. The composition for forming a conductive pattern according to claim 1 or 2, wherein an aspect ratio of the silver particles is 5 to 200.

4. The composition for forming a conductive pattern according to any one of claims 1 to 3, wherein the mass ratio of the copper particles and the silver particles, represented by copper particles : silver particles, is 99:1 to 70:30.

5. The composition for forming a conductive pattern according to any one of claims 1 to 4, wherein the shape of the copper particles is spherical, and the number median diameter D50 of the particles is 100 nm to 10 µm.

6. The composition for forming a conductive pattern according to any one of claims 1 to 5, further comprising a reducing agent.

7. The composition for forming a conductive pattern according to claim 6, wherein the reducing agent is a polyhydric alcohol, a carboxylic acid, or a polyalkylene glycol.

8. The composition for forming a conductive pattern according to claim 7, wherein the polyhydric alcohol is ethylene glycol, propylene glycol, or glycerin.

9. A conductive pattern formation method, comprising:
preparing a composition for forming a conductive pattern according to any one of claims 1 to 8, and
applying photo irradiation to the composition for forming a conductive pattern.

10. The conductive pattern formation method according to claim 9, wherein the light to be irradiated to the composition is a pulse light having a wavelength of 200 to 3000 nm.

11. The conductive pattern formation method according to claim 9 or 10, wherein the photo irradiation is performed in air.

## Patentansprüche

1. Zusammensetzung zum Bilden eines leitfähigen Musters mittels Lichtbestrahlung, welche umfasst:
Kupferteilchen,
plättchenförmige Silberteilchen mit einer jeweiligen Dicke von 10 bis 200 nm und
ein Bindemittelharz,
wobei das Massenverhältnis der Kupferteilchen und der Silberteilchen, ausgedrückt als Kupferteilchen:Silberteilchen, 99:1 bis 50:50 ist.

2. Zusammensetzung zum Bilden eines leitfähigen Musters nach Anspruch 1, wobei die Dicke der Silberteilchen 20 bis 70 nm ist.

3. Zusammensetzung zum Bilden eines leitfähigen Musters nach Anspruch 1 oder 2, wobei das Längen-Breiten-Verhältnis der Silberteilchen 5 bis 200 nm ist.

4. Zusammensetzung zum Bilden eines leitfähigen Musters nach einem der Ansprüche 1 bis 3, wobei das Massenverhältnis der Kupferteilchen und der Silberteilchen, ausgedrückt als Kupferteilchen:Silberteilchen, 99:1 bis 70:30 ist.

5. Zusammensetzung zum Bilden eines leitfähigen Musters nach einem der Ansprüche 1 bis 4, wobei die Form der Kupferteilchen kugelförmig ist und der Zahlenmedian-Durchmesser D50 der Teilchen 100 nm bis 10 µm ist.

6. Zusammensetzung zum Bilden eines leitfähigen Musters nach einem der Ansprüche 1 bis 5, sie außerdem ein Reduktionsmittel enthält.

7. Zusammensetzung zum Bilden eines leitfähigen Musters nach Anspruch 6, wobei das Reduktionsmittel ein mehrwertiger Alkohol, eine Carbonsäure oder ein Polyalkylenglykol ist.

8. Zusammensetzung zum Bilden eines leitfähigen Musters nach Anspruch 7, wobei der mehrwertige Alkohol Ethylenglykol, Propylenglykol oder Glycerin ist.

9. Verfahren zum Bilden eines leitfähigen Musters, welches umfasst:
das Herstellen einer Zusammensetzung zum Bilden eines leitfähigen Musters nach einem der Ansprüche 1 bis 8 und
das Beaufschlagen der Zusammensetzung zum Bilden eines leitfähigen Musters mit Lichtstrahlung.

10. Verfahren zum Bilden eines leitfähigen Musters nach Anspruch 9, wobei das auf die Zusammensetzung zu strahlende Licht ein Pulslicht einer Wellenlänge von 200 bis 3 000 nm ist.

11. Verfahren zum Bilden eines leitfähigen Musters nach Anspruch 9 oder 10, wobei die Lichtbestrahlung in Luft durchgeführt wird.

## Revendications

1. Composition pour former un motif conducteur par irradiation de lumière, comprenant :
des particules de cuivre,
des particules d'argent en feuillets ayant chacune une épaisseur de 10 à 200 nm, et
une résine liante,
dans laquelle le rapport de masse des particules de cuivre et des particules d'argent, représenté par particules de cuivre/particules d'argent, est de 99/1 à 50/50.

2. Composition pour former un motif conducteur selon la revendication 1, dans laquelle l'épaisseur des particules d'argent est de 20 à 70 nm.

3. Composition pour former un motif conducteur selon la revendication 1 ou 2, dans laquelle un rapport des dimensions des particules d'argent est de 5 à 200.

4. Composition pour former un motif conducteur selon l'une quelconque des revendications 1 à 3, dans laquelle le rapport de masse des particules de cuivre et des particules d'argent, représenté par particules de cuivre/particules d'argent, est de 99/1 à 70/30.

5. Composition pour former un motif conducteur selon l'une quelconque des revendications 1 à 4, dans laquelle la forme des particules de cuivre est sphérique, et le diamètre médian en nombre D50 des particules est de 100 nm à 10 µm.

6. Composition pour former un motif conducteur selon l'une quelconque des revendications 1 à 5, comprenant en outre un agent réducteur.

7. Composition pour former un motif conducteur selon la revendication 6, dans laquelle l'agent réducteur est un alcool polyhydrique, un acide carboxylique ou un polyalkylène glycol.

8. Composition pour former un motif conducteur selon la revendication 7, dans laquelle l'alcool polyhydrique est l'éthylène glycol, le propylène glycol ou la glycérine.

9. Procédé de formation de motifs conducteurs, comprenant :
la préparation d'une composition pour former un motif conducteur selon l'une quelconque des revendications 1 à 8, et
l'application d'une irradiation de lumière sur la composition pour former un motif conducteur.

10. Procédé de formation de motifs conducteurs selon la revendication 9, dans lequel la lumière à irradier sur la composition est une lumière pulsée ayant une longueur d'onde de 200 à 3 000 nm.

11. Procédé de formation de motifs conducteurs selon la revendication 9 ou 10, dans lequel l'irradiation de lumière est réalisée dans l'air.
